# EUROPEAN PATENT APPLICATION

(11) **EP 1 679 276 A1**
(43) Veröffentlichungstag der Anmeldung: **12.07.2006**
(21) Anmeldenummer: 04792118.4
(22) Anmeldetag: 07.10.2004
(51) Int. Cl.: B65H 41/00, H01L 21/78

(54) **KLEBEBANDABZIEHVORRICHTUNG**

(30) Priorität: 17.10.2003 JP 2003357168
(71) Anmelder: LINTEC KABUSHIKI KAISHA also known as LINTEC CORPORATION (formerly EFUESUKEI KABUSHIKI KAISHA also known as FSK CORPORATION), Tokyo (JP)
(72) Erfinder: AKECHI, Takeshi, Tokyo 1730001 (JP)
(74) Vertreter: Jeck, Anton
(86) Internationale Anmeldenummer: PCT/JP2004/014820
(87) Internationale Veröffentlichungsnummer: WO 2005/037698

(57) **Zusammenfassung**

Eine Vorrichtung zum Ablösen eines Klebebands wird vorgeschlagen, mit der zerbrochene Klebebänder von einem plattenförmigen Körper leicht und wirksam abgelöst werden können.

Eine Vorrichtung zum Ablösen eines auf die Oberfläche eines Wafers (plattenförmigen Körpers) W geklebten und in chipgroße Stücke zerbrochenen Oberflächenschutzbands (Klebebands) 2a vom Wafer W umfasst Ablösebandzuführmittel zur Zuführung eines Ablösebands zum plattenförmigen Körper, der auf einem Saugtisch gehalten wird, Ablösebandklebemittel zum Ankleben des aus den Ablösebandzuführmitteln zugeführten Ablösebands an die ganze Fläche des auf der Oberfläche des plattenförmigen Körpers aufgeklebten Klebebands, Heizmittel zur Erhitzung des an der ganzen Fläche des Klebebands durch die Ablösebandklebemittel angeklebten Ablösebands zusammen mit dem Ablöseband, Ablösemittel zum Ablösen des auf das Ablöseband durch Erhitzen mit den Heizmitteln aufgeklebten Klebebands vom plattenförmigen Körper zusammen mit dem Ablöseband und Einsammelmittel zum Einsammeln des Klebebands und des vom plattenförmigen Körper durch die Bandablösemittel abgelösten Ablösebands.

## Beschreibung

Die vorliegende Erfindung betrifft eine Vorrichtung zum Ablösen eines Klebebands von einem plattenförmigen Körper, beispielsweise eines Oberflächenschutzbands, das auf der Oberfläche des plattenförmigen Körpers eines Halbleiterwafers oder dergleichen aufgeklebt ist, der in chipgroße Stücke aufgeteilt worden ist.

Bei einem Halbleiterchip-Herstellungsverfahren in der elektronischen und optischen Industrie wird die Rückseite des Wafers, nachdem bestimmte Schaltungsmuster auf der Oberfläche eines Halbleiterwafers (im Folgenden nur Wafer genannt) gebildet worden sind, in Bezug auf den Boden befestigt, um dann die Waferstärke gleichmäßig zu vermindern oder einen Oxidfilm zu beseitigen, der während der Bildung der Schaltungsmuster erzeugt wurde, und um anschließend den Wafer in einzelne Schaltungen zur Herstellung der Halbleiterchips zu zerbrechen.

Übrigens können die geschliffenen Bruchstücke während des Schleifens eines Wafers gewonnen werden, und wenn die geschliffenen Bruchstücke in Kontakt mit einem Schaltungsmuster kommen, kann das Schaltungsmuster zerbrochen werden.

Deshalb ist ein Verfahren zum Kleben eines Oberflächenschutzbands auf die Oberfläche eines Wafers angewandt worden, um die Waferoberfläche zu schützen, das Wafer in diesem Zustand zu schleifen und das Oberflächenschutzband von der Waferoberfläche nach dem Schleifen abzulösen. Eine Ablösevorrichtung zur Durchführung dieses Verfahrens ist ebenfalls bereits vorgeschlagen worden (s. Patentschrift 1).

Auch ein Zerbrechen eines Wafers in einzelne Schaltungen ergibt die Produktion von Schnittbruchstücken, und sogar die Schnittbruchstücke, wenn sie in Kontakt mit einem Schaltungsmuster kommen, können das Schaltungsmuster ebenfalls zerbrechen, so dass ein Verfahren zum In-Würfel-Schneiden des Wafers mit dem Oberflächenschutzband vorgeschlagen worden ist, das auf der Oberfläche des Wafer angeklebt bleibt, wobei die zerbrochenen Oberflächenschutzbänder von der Waferoberfläche nach dem In-Würfel-Schneiden abgelöst werden (s. Patentschrift 2).
Patentschrift 1: japanische Offenlegungsschrift 11-16862,
Patentschrift 2: japanische Offenlegungsschrift 8-22330093.

### Zusammenfassung der Erfindung

### a) Von der Erfindung zu lösendes Problem

Die in der Patentschrift 1 beschriebene Ablösevorrichtung ist jedoch eine Vorrichtung zum Ablösen eines Oberflächenschutzbands von einem Wafer vor dessen In-Würfel-Schneiden, so dass das Wafer in Würfel geschnitten wird, nachdem das Oberflächenschutzband vom Wafer abgelöst worden ist, so dass möglicherweise das vorher genannte Problem aufgrund des Schneidens in Bruchstücke auftritt, das durch das In-Würfel-Schneiden und Kontaktieren mit den Schaltungsmustern erzeugt wird.

Das in der Patentschrift 2 beschriebene Ablöseverfahren umfasst das Ankleben eines Oberflächenschutzbands, das eine Klebeschicht auf einer Wärmeschrumpfbasis aufweist, auf einen plattenförmigen Körper und das Erhitzen im Wesentlichen nur dieser Klebeschicht, wenn das Oberflächenschutzband abgelöst worden ist, wobei die zerbrochenen Oberflächenschutzbänder schrumpfen und sich biegen, damit ihre Kontaktflächen mit den plattenförmigen Körpern vermindert werden, so dass es leichter ist, das Oberflächenschutzband vom plattenförmigen Körper abzulösen.

Das vorbeschriebene Ablöseverfahren erfordert jedoch die Entfernung der entsprechenden geschrumpften und gebogenen Oberflächenschutzbänder von der Oberfläche des plattenförmigen Körpers durch Mittel, wie Verbrennen mit heißer Pressluft, durch Absorption und durch Ablösen mit Hilfe eines Klebebands, und weist das Problem der geringen Wirksamkeit auf, weil diese Vorgänge in den meisten Fällen von Hand ausgeführt werden.

Die vorliegende Erfindung ist hinsichtlich der oben erwähnten Probleme entwickelt worden, und es ist Aufgabe der Erfindung, eine Vorrichtung zum Ablösen eines Klebebands zu schaffen, mit der es möglich ist, zerbrochene Klebebänder von plattenförmigen Körpern in einfacher und wirksamer Weise abzulösen.

### b) Mittel zur Problemlösung

Um die vorstehende Aufgabe zu lösen, ist die Vorrichtung zum Ablösen eines auf der Oberfläche eines plattenförmigen Körpers aufgeklebten und in chipgroße Stücke des plattenförmigen Körpers zerbrochenen Klebebands durch folgende Mittel gekennzeichnet:
- Ablösebandzuführmittel zur Zuführung eines Ablösebands zum plattenförmigen Körper, der auf einem Saugtisch gehalten wird,
- Ablösebandklebemittel zum Ankleben des aus den Ablösebandzuführmitteln zugeführten Ablösebands an die ganze Fläche des auf der Oberfläche des plattenförmigen Körpers aufgeklebten Klebebands,
- Heizmittel zur Erhitzung des an der ganzen Fläche des Klebebands durch die Ablösebandklebemittel angeklebten Ablösebands zusammen mit dem Ablöseband,
- Ablösemittel zum Ablösen des auf das Ablöseband durch Erhitzen mit den Heizmitteln aufgeklebten Klebebands vom plattenförmigen Körper zusammen mit dem Ablöseband und
- Einsammelmittel zum Einsammeln des Klebebands und des vom plattenförmigen Körper durch die Bandablösemittel abgelösten Ablösebands.

Die Erfindung ist in Weiterbildung des Anspruchs 1 gemäß dem Anspruch 2 dadurch gekennzeichnet, dass ein endloses, blattförmiges Band als Ablöseband verwendet wird und dass die Ablösebandklebemittel und die Bandablösemittel durch eine gemeinsame Rolleneinheit bei der Erfindung nach Anspruch 1 gebildet sind.

Die Erfindung ist ferner in Weiterbildung des Anspruchs 1 nach Anspruch 3 dadurch gekennzeichnet, dass ein Band, das vorher in Übereinstimmung mit der Oberflächenform des plattenförmigen Körpers zerschnitten ist, als Ablöseband verwendet wird, wobei ein zweites Klebeband, das an ein Ende des Ablösebands geklebt ist, gehalten und von einem Ablösekopf abgezogen wird, wobei das Klebeband vom plattenförmigen Körper zusammen mit dem Ablöseband abgelöst wird.

Die Erfindung ist in Weiterbildung des Anspruchs 1 nach Anspruch 4 dadurch gekennzeichnet, dass das Klebeband eine Klebeschicht aufweist, das auf einer Wärmeschrumpfbasis aufgebracht ist.

Die Erfindung ist in Weiterbildung des Anspruchs 4 nach Anspruch 5 dadurch gekennzeichnet, dass die Klebeschicht des Klebebands aus einem mit Ultraviolettlicht härtbarem Klebstoff hergestellt ist und dass die Vorrichtung ferner ein Ultraviolettlicht aussendendes Mittel zur Beleuchtung des Klebebands mit Ultraviolettstrahlen aufweist.

Die Erfindung ist in Weiterbildung des Anspruchs 1 nach Anspruch 6 dadurch gekennzeichnet, dass Kühlmittel zum Kühlen des Ablösebands und des durch die Heizmittel erhitzten Klebebands vorgesehen sind.

### c) Wirkungen der Erfindung

Gemäß Anspruch 1 der Erfindung kleben die zerbrochenen Klebebänder, da das über die ganze Fläche des Klebebands geklebte Ablöseband zusammen mit dem Klebeband erhitzt wird, am Ablöseband, so dass die Klebebänder vom plattenförmigen Körper zusammen mit dem Ablöseband abgelöst werden, und dann werden die abgelösten Klebebänder und das Ablöseband eingesammelt, so dass es möglich ist, die zerbrochenen Klebebänder vom plattenförmigen Körper leicht abzulösen. Diese Schritte werden von der Ablösevorrichtung durchgeführt, die die Ablösebandzuführmittel, die Ablösebandklebemittel, die Heizmittel, die Bandablösemittel und die Einsammelmittel aufweist, so dass es möglich ist, den Vorgang zum Ablösen der Klebebänder wirksam auszuführen.

Gemäß Anspruch 2 der Erfindung können die zerbrochenen Klebebänder, da ein endloses, blattförmiges Band als Ablöseband verwendet wird, nacheinander an das endlose, blattförmige Band angeklebt werden, um die Klebebänder vom plattenförmigen Körper zwecks Einsammelns wirksam abzulösen. Wenn die Ablösebandklebemittel und die Bandablösemittel mit einer gemeinsamen Rolleneinheit ausgestattet werden, kann der Aufbau der Ablösevorrichtung vereinfacht und können die Kosten auch vermindert werden.

Gemäß Anspruch 3 der Erfindung wird ein Band, das vorher in Übereinstimmung mit der Oberflächenform des plattenförmigen Körpers geschnitten ist, als Ablöseband verwendet. Durch Halten und Abziehen eines zweiten Klebebands, das an ein Ende des Ablösebands mittels eines Ablösekopfs geklebt ist, kann das Klebeband vom plattenförmigen Körper zusammen mit dem Ablöseband leicht und wirksam abgelöst werden.

Da ein Band als Klebeband verwendet wird, das eine auf einer Wärmeschrumpfbasis aufgebrachte Klebeschicht aufweist, werden gemäß Anspruch 4 der Erfindung die derart aufgebrachten Schrumpfgegenstände, wie das Klebeband, erhitzt, so dass entsprechende zerbrochene Klebebänder gebogen und in Kontakt mit dem plattenförmigen Körper auf einer verminderten Fläche gebracht werden. Daher löst sich jedes Klebeband vom plattenförmigen Körper leichter, und die Klebebänder kleben am Ablöseband besser, werden vom plattenförmigen Körper besser abgelöst und werden zusammen mit dem Ablöseband eingesammelt.

Da Ultraviolettstrahlen auf ein Klebeband gerichtet werden, das eine Klebeschicht aus mit Ultraviolettlicht härtbarem Klebstoff aufweist, wobei die Aushärtung mittels der Ultraviolettstrahlenaussendungsmittel erfolgt, wird gemäß Anspruch 5 der Erfindung die Klebeschicht des Klebebands ausgehärtet, um die Klebekraft des Klebebands zu schwächen, so dass jedes der zerbrochenen Klebebänder vom plattenförmigen Körper leichter abgelöst werden kann. Diese zerbrochenen Klebebänder können vom plattenförmigen Körper zusammen mit dem Ablöseband eingesammelt und leichter abgelöst werden.

Durch Kühlen des erhitzten Ablösebands kann gemäß Anspruch 6 der Erfindung die Betriebszeit vermindert werden, so dass der Wirkungsgrad weiter erhöht wird.

### Kurzbeschreibung der Zeichnungen

Die Erfindung wird nun anhand von Ausführungsbeispielen näher erläutert. Es zeigen:
- Fig. 1: eine Seitenansicht einer Ablösevorrichtung gemäß einem ersten Ausführungsbeispiel der vorliegenden Erfindung,
- Fig. 2: eine Draufsicht auf die Ablösevorrichtung der Fig. 1,
- Fig. 3: eine Seitenansicht eines Saugtischteils der Fig. 1,
- Fig. 4: eine Draufsicht auf den Saugtischteil der Fig. 3,
- Fig. 5: einen Querschnitt durch einen Wafer mit einem auf dessen Oberfläche aufgeklebten Oberflächenschutzband,
- Fig. 6: einen Querschnitt durch das Oberflächenschutzband der Fig. 5,
- Figuren 7-14: Erläuterungsdiagramme, die ein Ablöseverfahren unter Verwendung der Ablösevorrichtung der Fig. 1 in der Reihenfolge einzelner Schritte darstellen,
- Fig. 15: einen Querschnitt durch einen Wafer mit einem Oberflächenschutzband und einem auf dessen Oberfläche aufgeklebten Ablöseband für ein Ablöseverfahren, das unter Verwendung der Ablösevorrichtung der Fig. 1 durchgeführt wird,
- Fig. 16: einen Querschnitt durch den Wafer der Fig. 15, der zeigt, wie ein Ablöseband auf das Oberflächenschutzband auf der Waferfläche nach dem Heizschritt des Ablöseverfahrens aufgeklebt wird, das unter Verwendung der Ablösevorrichtung der Fig. 1 abläuft.
- Fig. 17: eine Draufsicht auf ein zweites Ausführungsbeispiel einer Ablösevorrichtung gemäß der vorliegenden Erfindung,
- Figuren 18-20: Erläuterungsdiagramme, die ein angewandtes Ablöseverfahren unter Verwendung einer dritten Ausführung der vorliegenden Erfindung in der Reihenfolge einzelner Schritte wiedergeben,
- Fig. 21: einen Querschnitt durch einen Wafer, der den Zustand eines Oberflächenschutzbands und eines Ablösebands nach dem Heizschritt des Ablöseverfahrens darstellt, das unter Verwendung der Ablösevorrichtung gemäß einer dritten Ausführung der vorliegenden Erfindung abläuft, und
- Fig. 22: einen Querschnitt durch einen Wafer, der darstellt, wie das Ablöseband und das Oberflächenschutzband von der Waferfläche bei dem Ablöseverfahren abgelöst werden, das unter Verwendung der Ablösevorrichtung gemäß der dritten Ausführung der vorliegenden Erfindung abläuft.

### Bestes Ausführungsbeispiel zur Ausführung der Erfindung

Im Folgenden werden Ausführungsbeispiele der vorliegenden Erfindung anhand der beigefügten Zeichnungen beschrieben.

### Erstes Ausführungsbeispiel

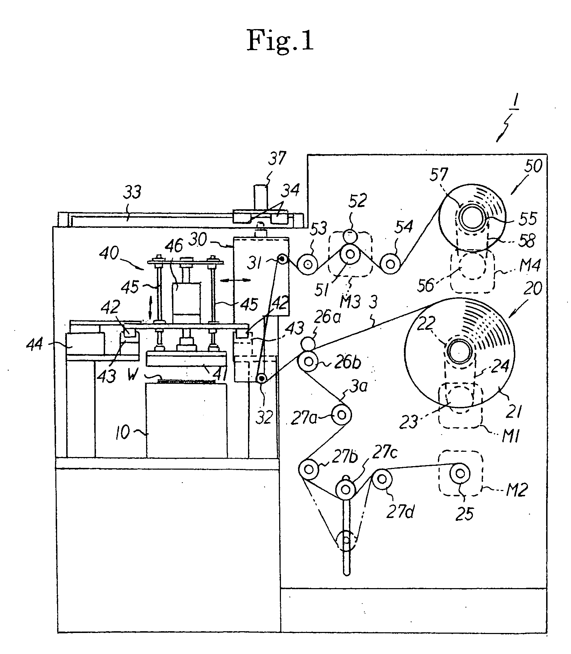

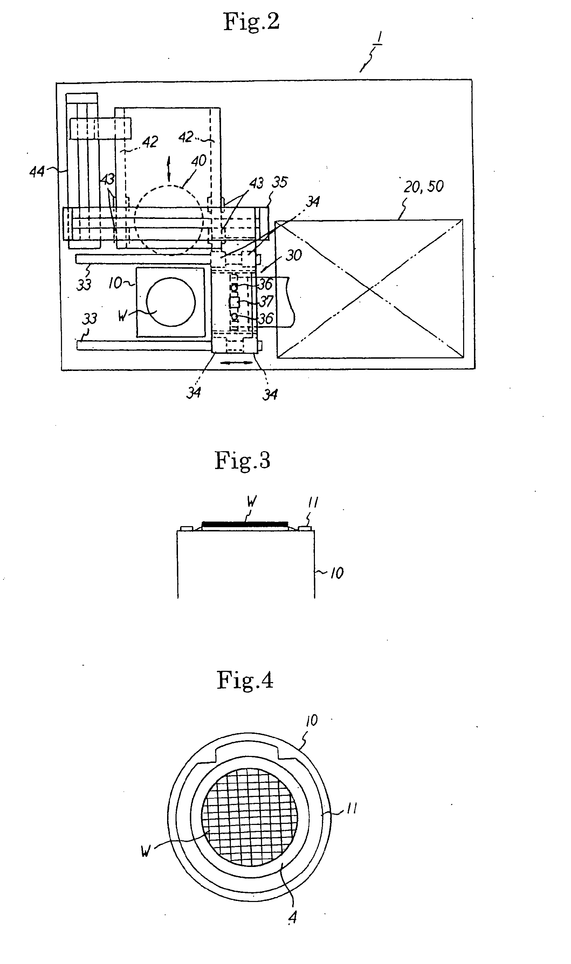

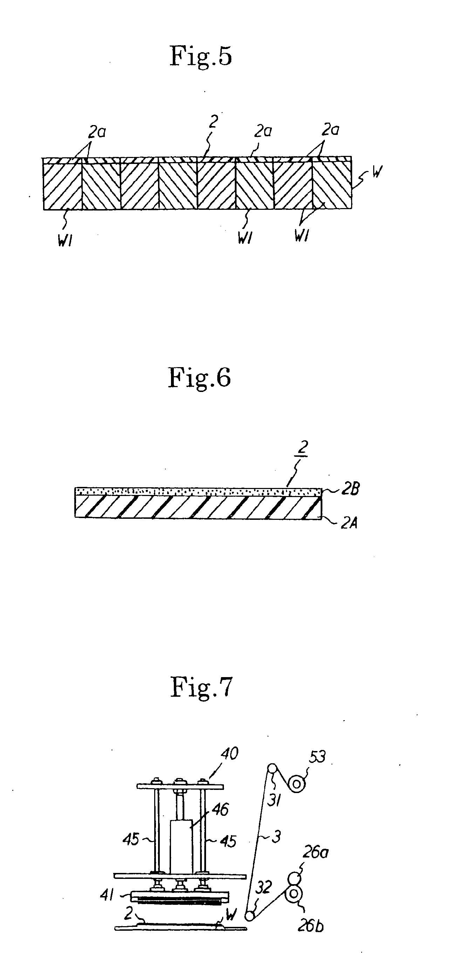

Fig. 1 zeigt eine Seitenansicht einer Ablösevorrichtung gemäß einem ersten Ausführungsbeispiel der vorliegenden Erfindung; Fig. 2 zeigt eine Draufsicht auf die Ablösevorrichtung; Fig. 3 zeigt eine Seitenansicht eines Saugtischteils der Ablösevorrichtung; Fig. 4 zeigt eine Draufsicht auf den Saugtischteil; Fig. 5 zeigt einen Querschnitt durch einen Wafer mit einem auf dessen Oberfläche aufgeklebten Oberflächenschutzband (Klebeband), und Fig. 6 zeigt einen Querschnitt durch das Oberflächenschutzband (Klebeband).

Die Ablösevorrichtung 1 gemäß dieser Ausführung ist eine Vorrichtung zum Ablösen eines Oberflächenschutzbands 2a, das auf einem Wafer W aufgeklebt und, wie in Fig. 5 dargestellt ist, zerbrochen worden ist, von der Oberfläche des Wafers W in einem Halbleiterherstellungsprozess.

Hier ist ein Oberflächenschutzband 2 auf einer Oberfläche des Wafers W aufgeklebt, nachdem bestimmte Schaltungsmuster auf dieser Oberfläche gebildet worden sind, wie es in Fig. 5 dargestellt ist. Die Rückseite des Wafers W in diesem Zustand ist in Bezug auf den Boden festgelegt. Danach wird der Wafer W zusammen mit dem Oberflächenschutzband 2 auf der Basis einzelner Schaltungen in Würfel zerlegt (zerbrochen). In Fig. 5 bezeichnet 2a die zerbrochenen Oberflächenschutzbänder und W1 die zerbrochenen Wafer.

Übrigens weist das Oberflächenschutzband 2 eine Klebeschicht 2B auf, die auf der Oberfläche einer Wärmeschrumpfbasis 2A aufgebracht ist, die aus einem genügend dehnbaren Polyethylen besteht, wie in Fig. 6 dargestellt ist. Die Klebeschicht 2B, die aus einem Klebemittel auf Akrylbasis besteht, ist auf die Oberfläche des Wafers W aufgeklebt, wobei das Oberflächenschutzband 2 auf die Oberfläche des Wafers W aufgeklebt wird.

Wie in Fig. 1 dargestellt ist, weist die Ablösevorrichtung 1 gemäß diesem Ausführungsbeispiel Folgendes auf:
- 1): einen Saugtisch 10,
- 2): eine Ablösebandeinheit 20, die ein Ablösebandzuführmittel zur Zuführung eines Ablösebands 3 zum Wafer W darstellt, der auf einem Saugtisch 10 angeordnet ist,
- 3): eine Klebe- und Ablöserolleneinheit 30, die ein Ablöseband-klebemittel zum Ankleben des Ablösebands 3 aufweist, das durch die Ablösebandeinheit 20 der ganzen Oberfläche des Oberflächenschutzbands 2 (2a) zugeführt wird, das auf der Oberfläche des Wafer W aufgeklebt ist, und ein Bandablösemittel zum Ablösen des auf dem Ablöseband 3 aufgeklebten Oberflächenschutzbands 2 (2a) von der Oberfläche des Wafers W zusammen mit dem Ablöseband 3 durch Zuführen von Wärme durch eine Heiz- und Kühleinheit 40, die später beschrieben wird,
- 4): die Heiz- und Kühleinheit 40, die ein Heizmittel zum Erhitzen des auf der ganzen Oberfläche des Oberflächenschutzbands 2 (2a) durch die Klebe- und Ablöserolleneinheit 30 zusammen mit dem Oberflächenschutzband 2 (2a) aufgeklebten Ablösebands aufweist und die ein Kühlmittel zum Kühlen des Ablösebands 3 und des Oberflächenschutzbands 2 (2a) aufweist, die beide durch die Heizmittel erhitzt wurden, und
- 5): eine Bandaufwickeleinheit 50, die das Einsammelmittel zum Einsammeln des Oberflächenschutzbands 2 (2a) und des Ablösebands 3 darstellt, die beide von der Oberfläche des Wafers W durch die Klebe- und Ablöserolleneinheit 30 abgelöst worden sind.

Im Folgenden werden der Saugtisch 10, die Ablösebandeinheit 20, die Klebe- und Ablöserolleneinheit 30, die Heiz- und Kühleinheit 40 und die Bandaufwickelvorrichtung ausführlich beschrieben.

### 1) Saugtisch:

Wie in Fig. 4 gezeigt ist, ist der Wafer W auf einem Ringrahmen 11 durch ein Würfelband 4 auf derjenigen Seite befestigt, die entgegengesetzt zur Oberfläche liegt, auf der das Oberflächenschutzband 2 aufgeklebt ist, und der Wafer zusammen mit dem Oberflächenschutzband 2 zerbrochen; Wafer und Oberflächenschutzband sind auf einem zylindrischen Saugtisch 10 angeordnet und werden durch diesen getragen. Der Ringrahmen 11 und der Wafer W werden beide dadurch gehalten, dass die untere Seite des Wafers durch Saugen festgehalten wird.

Während das Ablöseband 3 auf der ganzen Fläche des Oberflächenschutzbands 2 aufgeklebt ist, das wiederum auf der Oberfläche des Wafers W durch die Klebe- und Ablöserolleneinheit 30 aufgeklebt ist, wie später noch beschrieben wird, ist aus Bezugsgründen die Höhe des Ringrahmens 11 in diesem Fall um einen Schritt niedriger als die Oberfläche des Wafers W gesetzt, so dass das Ablöseband 3 nicht auf dem Ringrahmen 11 klebt.

### 2) Ablösebandeinheit:

Wie in Fig. 1 gezeigt ist, befindet sich in der Ablösebandeinheit 20 ein rollenförmiger Ablösebandvorrat 21 mit einem Ablöseband 3, das dort aufgewickelt ist. Der Vorrat 21 wird drehbar gelagert, und eine Riemenscheibe 22 ist mit einer Welle des Vorrats 21 gekoppelt. Ferner ist ein Drehmomentmotor M1 in der Nähe des Vorrats 21 angeordnet, und ein Endlosriemen 24 ist um die Riemenscheibe 22 und eine Riemenscheibe 23 gespannt, die mit dem Ende einer Abtriebswelle des Drehmomentmotors M1 gekoppelt sind.

Für das Ablöseband 3 wird hier ein wärmeempfindliches Band verwendet, das eine wärmeempfindliche Klebeschicht aufweist, die auf einer wärmefesten Folie beispielsweise aus Polyethylenterephthalat aufgebracht ist, und die wärmeempfindliche Klebeschicht ist mit einer Abdeckschicht 3a abgedeckt.

Ein weiterer Motor M2 ist unter dem Drehmomentmotor M1 angeordnet, und eine Abdeckschichtaufwickelwelle 25 ist mit einer Abtriebswelle des Motors M2 zum Aufwickeln der Abdeckschicht 3a gekoppelt, die vom Ablöseband 3 getrennt worden ist.

Ferner weist die Ablösebandeinheit 20 eine obere Rolle 26a und eine untere Rolle 26b zum Einfassen des vom Ablösebandvorrat 21 zugeführten Ablösebands 3 auf, um die Abdeckschicht 3a vom Ablöseband 3 zu trennen; die Einheit 20 weist ferner Führungsrollen 27a-27d zur Führung der vom Ablöseband 3 getrennten Abdeckschicht 3a auf. Eine Führungsrolle 27c bildet hier eine Pufferrolle, die sich längs einer Führungsnut 28 auf und ab bewegen kann, die in vertikaler Richtung gebildet ist. Diese Pufferrolle 27c wird immer durch ein nicht gezeigtes Druckmittel nach unten gehalten, um eine Funktion des Ziehens der Abdeckschicht 3a auszuführen, damit diese nicht durchhängt.

### 3) Klebe- und Ablöserolleneinheit:

Wie in Fig. 1 gezeigt ist, weist die Klebe- und Ablöserolleneinheit 30 zwei drehbar gelagerte Rollen 31, 32 auf, die übereinander angeordnet sind, wobei diese Einheit 30 mittels einer Gleitbahn 34 von einem Paar von Gleitschienen 33 drehbar gehalten wird, die parallel auf dem Körper der Vorrichtung angeordnet sind. Dann wird die Klebe- und Ablöserolleneinheit 30 wechselseitig in den in der Figur dargestellten Richtungen auf den Gleitschienen 33 durch einen einachsigen Automaten 35 (s. Fig. 2) bewegt, der parallel zu den Gleitschienen 33 am Vorrichtungskörper angeordnet ist.

Wie in Fig. 2 gezeigt ist, wird die Klebe- und Ablöserolleneinheit 30 auch derart gestützt, dass sie sich längs zweier übereinander angeordneter Führungswellen 36 bewegen kann, und sie wird längs den Führungswellen 36 von einem vertikal bewegbaren Zylinder 37 auf und ab bewegt.

Das Ablöseband 3, von dem die Abdeckschicht 3a entfernt worden ist, wird um die Rollen 31, 32 der Klebe- und Ablöserolleneinheit 30 geführt.

### 4) Heiz- und Kühleinheit:

Wie in Fig. 1 dargestellt ist, weist die Heiz- und Kühleinheit 40 einen Heizkörper 41 als Heizmittel und ein nicht gezeigtes Kühlmittel auf, beispielsweise einen Kühlventilator oder dergleichen. Diese Einheit 40 wird von einem Paar linker und rechter Gleitschienen 42 getragen, die senkrecht zu den Gleitschienen 33 angeordnet sind, so dass sie in einer senkrecht zum Blatt der Fig. 1 stehenden Richtung in einer Gleitbahn 43 bewegt werden können. Ferner ist ein Gleitzylinder 44 parallel zu den Gleitschienen 42 derart angeordnet, dass sich die Heiz- und Kühleinheit 40 wechselseitig auf den Gleitschienen 42 bewegen kann (s. Fig. 2).

Der Heizkörper 41 der Heiz- und Kühleinheit 40 wird ferner derart getragen, dass er sich längs einer Vielzahl von Führungswellen 45 auf und ab bewegen kann, und diese Bewegung wird mittels eines vertikal bewegbaren Zylinders 46 ausgeführt (s. Fig. 2).

### 5) Bandaufwickeleinheit:

Wie in Fig. 1 dargestellt ist, ist die Bandaufwickeleinheit 50 über der Ablösebandeinheit 20 angeordnet. Diese Bandaufwickeleinheit 50 umfasst eine durch einen Motor M3 drehangetriebene Zuführrolle 51, eine in Kontakt mit der Zuführrolle 51 stehende und durch diese drehangetriebene Quetschrolle 52, auf beiden Seiten der Quetschrolle 52 angeordnete Führungsrollen 53, 54 und eine Ablösebandaufwickelwelle 55 zum Aufwickeln des Ablösebands 3 zusammen mit dem Oberflächenschutzband 2 (2a), das auf diesem Ablöseband aufgeklebt ist. Ferner ist ein Drehmomentmotor M4 in der Nähe der Ablösebandaufwickelwelle 55 angeordnet. Ein Endlosriemen 58 ist um eine Riemenscheibe 56, die auf einem Ende der Abtriebswelle des Drehmomentmotors M4 sitzt, und eine Riemenscheibe 57 geführt, die mit der Ablösebandaufwickelwelle 55 gekoppelt ist.

Das Ablöseband 3, das der Bandaufwickeleinheit 50 über die Rolle 31 der Klebe-und Ablöserolleneinheit 30 zugeführt wird, und das auf diesem Ablöseband aufgeklebte Oberflächenschutzband 2 (2a) werden über die Führungsrolle 53 geleitet und durch die Zuführrolle 51 und die Quetschrolle 52 eingefasst. Sie erreichen über die Führungsrolle 54 die Ablösebandaufwickelwelle 55 und werden um diese gewickelt sowie damit eingesammelt.

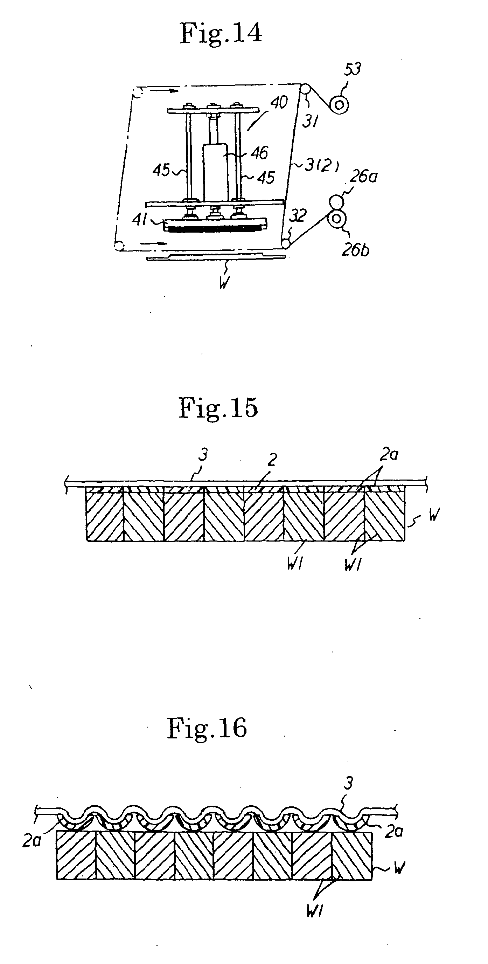

Nun wird ein Verfahren zum Ablösen der zerbrochenen Oberflächenschutzbänder 2a anhand der Figuren 7 bis 16 beschrieben, wobei die Wirkungsweise der Ablösevorrichtung 1 erläutert wird, die den vorstehend beschriebenen Aufbau aufweist. Die Figuren 7 bis 14 sind Erläuterungsdiagramme, die das Ablöseverfahren in Schrittreihenfolge zeigen. Die Fig. 15 zeigt einen Querschnitt, der darstellt, wie das Ablöseband an das Oberflächenschutzband auf der Oberfläche eines Wafers angeklebt wird. Die Fig. 16 zeigt einen Querschnitt, der den Zustand des Oberflächenschutzbands und des Ablösebands nach dem Erhitzen darstellt.

Das Ablöseverfahren gemäß diesem Ausführungsbeispiel besteht darin, dass die auf die Oberfläche des Wafers W aufgeklebten und in chipgroße Stücke zerbrochenen Oberflächenschutzbänder 2a von der Oberfläche der Wafer W1 abgelöst werden, die in der gleichen Weise zerbrochen worden sind, und dass die folgenden Schritte, nämlich der Ablösebandklebeschritt, der Heiz- und Kühlschritt und der Bandablöseschritt, ausgeführt werden.

### 1) Ablösebandklebeschritt:

Wie in Fig. 3 dargestellt ist, ist der Wafer W mit dem auf diesem geklebten Oberflächenschutzband 2 innerhalb des Ringrahmens 11 auf dem Saugtisch 10 angeordnet, wobei das Oberflächenschutzband 2 oben liegt, und durch den Sog zusammen mit dem Ringrahmen 11 durch ein Würfelband 4 festgehalten. Das Oberflächenschutzband 2 ist zusammen mit dem Wafer W durch das In-Würfel-Schneiden in chipgroße Stücke zerbrochen.

Zunächst wartet die Klebe- und Ablöserolleneinheit 30 an einer in den Figuren 1 und 2 gezeigten Stelle, an der die zwei Rollen 31, 32 der Klebe- und Ablöserolleneinheit 30 in den in Fig. 7 gezeigten Positionen stehen, wobei diese Rollen das zwischen ihnen sich erstreckende Ablöseband dazu bringen, neben dem Wafer W zu warten.

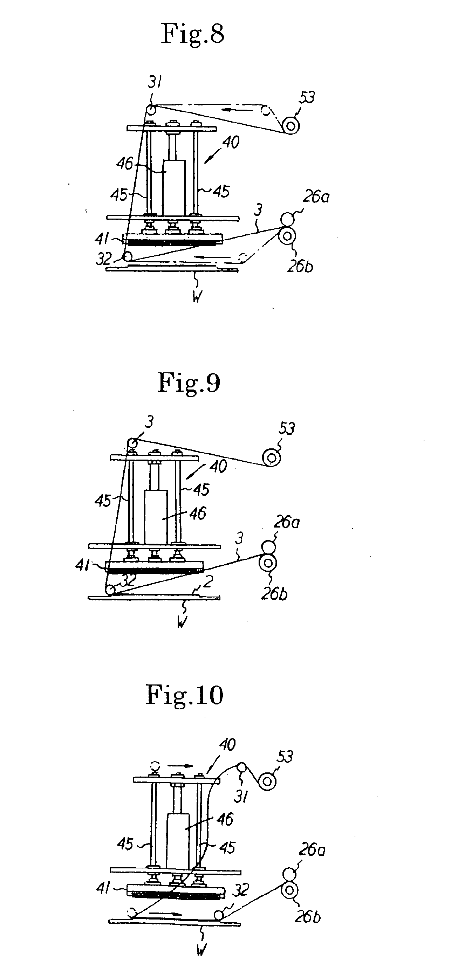

Da der einachsige Bewegungsautomat 35 zum Bewegen der Klebe- und Ablöserolleneinheit 30 in den Figuren 1 und 2 nach links längs den Gleitschienen 33 angetrieben wird, bewegen sich die Rollen 31, 32 der Klebe- und Ablöserolleneinheit 30 im vorbeschriebenen Zustand in Fig. 8 in der durch einen Pfeil angedeuteten Richtung von Positionen strichpunktierter Linien zu Positionen ausgezogener Linien. Der Motor M3 bleibt in diesem Fall ausgeschaltet und wird mit den Bewegungen der Rollen 31, 32 bewegt, wobei das von der Abdeckschicht 3a getrennte Ablöseband 3 vom Ablösebandvorrat 21 ausgezogen wird. Über dem Wafer W wird das zwischen der Rolle 32 und dem Rollenpaar 26a, 26b verlaufende Ablöseband 3 schräg angeordnet.

Während das Ablöseband 3 ausgezogen wird, wird es durch den Drehmomentmotor M1 mit einer bestimmten Spannung versehen. Wenn die Abdeckschicht 3a herausgezogen wird, wird auch ihr Durchhang mittels eines Druckmittels verstärkt, weil die Pufferrolle 27c zu einer Position bewegt wird, die in Fig. 1 durch eine strichpunktierte Linie angedeutet ist. Wenn das Ablöseband 3 an den Wafer W angeklebt worden ist, wird der Motor M2 eingeschaltet, der die Abdeckschicht 3a aufzuwickeln beginnt, wenn die Pufferrolle 27c durch einen nicht dargestellten Sensor in der strichpunktierten Position festgestellt worden ist.

Dann wird der vertikal bewegbare Zylinder 37 derart angetrieben, dass er die Klebe-und Ablöserolleneinheit 30 nach unten längs der Führungswelle 36 bewegt, so dass die Rolle 32 mit einem Ende der Oberfläche des Wafers W zusammen mit dem Ablöseband in engen Kontakt gerät, wie es in Fig. 9 dargestellt ist. Dabei wird das Ablöseband 3 an ein Ende des Oberflächenschutzbands 2 (2a) angeklebt, das auf der Oberfläche des Wafers W aufgeklebt ist. Der einachsige Bewegungsautomat 35 wird bei diesem Betriebszustand angetrieben, um die Klebe- und Ablöserolleneinheit 30 in den Figuren 1 und 2 nach rechts längs den Gleitschienen 33 zu bewegen.

Dann bewegen sich die Rollen 31, 32 der Klebe- und Ablöserolleneinheit 30 in der durch einen Pfeil angedeuteten Richtung von der Position der strichpunktierten Linie zur Position der ausgezogenen Linie in Fig. 10, und die Rolle 32 bewegt sich auf der Oberfläche des Wafers W, wobei sie das Ablöseband 3 auf das Oberflächenschutzband 2 (2a) drückt, so dass das Ablöseband 3 über die ganze Fläche des Oberflächenschutzbands 2 angeklebt wird (s. Fig. 15).

### 2) Heiz- und Kühlschritt:

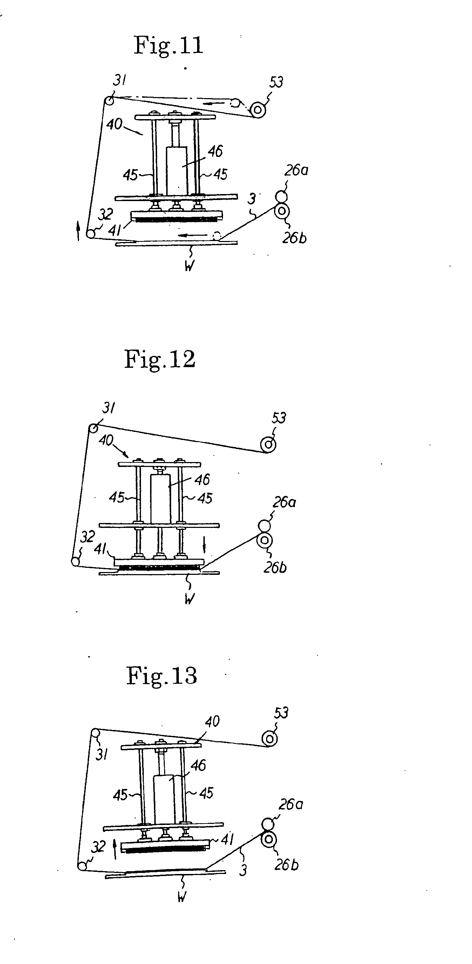

Wenn das Ablöseband 3 über die ganze Fläche des Oberflächenschutzbands 2 im Ablösebandklebeschritt angeklebt worden ist, wird der einachsige Bewegungsautomat 35 erneut eingeschaltet, wobei er die Klebe- und Ablöserollen-einheit 30 in den Figuren 1 und 2 nach links längs den Gleitschienen 33 bewegt. Dann wird der vertikal bewegbare Zylinder 37 angetrieben, der damit die Klebe- und Ablöserolleneinheit 30 an der Führungswelle 36 entlang nach oben bewegt. Dadurch wird die Rolle von der Oberfläche des Wafers W weg bewegt, und die Rollen 31, 32 der Klebe- und Ablöserolleneinheit 30 bewegen sich in einer durch einen Pfeil angedeuteten Richtung von der Position einer strichpunktierten Linie zu einer Position einer ausgezogenen Linie in Fig. 11.

Im vorbeschriebenen Betriebszustand wird der Gleitzylinder 44 derart angetrieben, dass er die Heiz- und Kühleinheit 40 in Fig. 2 längs den Gleitschienen 42 nach unten bewegt, so dass die Heiz- und Kühleinheit 40 über dem Wafer W angeordnet wird.

Darauf wird der vertikal bewegbare Zylinder 46 der Heiz- und Kühleinheit 40 derart angetrieben, dass er den Heizkörper 41 der Heiz- und Kühleinheit 40 längs den Führungswellen 45 nach unten bewegt, und der Heizkörper 41 wird mit dem Ablöseband 3 in Kontakt gebracht, das an das Oberflächenschutzband 2 (2a) auf der Oberfläche des Wafers W angeklebt worden ist, wie es in Fig. 12 dargestellt ist. In diesem Betriebszustand wird dann ein Heizelement des Heizkörpers 41 mit elektrischer Energie versorgt, so dass das Ablöseband 3 und das Oberflächenschutzband 2 (2a) auf eine bestimmte Temperatur erhitzt werden.

Die Erhitzungstemperatur und die Erhitzungszeit weisen hier abhängig vom Material des Oberflächenschutzbands 2 in typischer Weise die Größenordnung von 40-200°C (vorzugsweise 70-130°C) bzw. 0,5-120s (vorzugsweise 1-10s) auf.

Wie oben beschrieben wurde (s. Fig. 6), weist das Oberflächenschutzband 2 die Klebeschicht 2B auf, die auf der Oberfläche der Wärmeschrumpfbasis 2A aufgebracht ist, so dass bei ihrem Erhitzen die Wärmeschrumpfbasis 2A schrumpft und nachfolgend die entsprechenden zerbrochenen Oberflächenschutzbänder 2a gebogen werden, wie es in Fig. 16 dargestellt ist. Daher stehen die einzelnen zerbrochenen Oberflächenschutzbänder 2a mit der Oberfläche des Wafers W (W1) auf einer verminderten Fläche in Kontakt, so dass jedes Oberflächenschutzband 2a von der Oberfläche des Wafers W (W1) leicht abgelöst werden kann.

Darauf wird der vertikal bewegbare Zylinder 46 derart angetrieben, dass er den Heizkörper 41 der Heiz- und Kühleinheit 40 längs der Führungswelle 45 nach oben bewegt, so dass der Heizkörper 41 vom Wafer W weg bewegt wird, wie es in Fig. 13 dargestellt ist. In diesem Betriebszustand werden das Ablöseband 3 und das Oberflächenschutzband 2 durch nicht dargestellte Kühlmittel, wie einen Kühlventilator oder dergleichen, heruntergekühlt.

### 3) Bandablöseschritt:

Wenn das Ablöseband 3 und das Oberflächenschutzband 2 in der vorbeschriebenen Weise abgekühlt sind, wird der Gleitzylinder 44 derart angetrieben, dass er die Heiz-und Kühleinheit 40 in Fig. 2 längs den Gleitschienen 42 nach oben bewegt, so dass die Heiz- und Kühleinheit 40 über dem Wafer W zurückgezogen wird.

Wenn nun der einachsige Bewegungsautomat 35 derart angetrieben wird, dass er die Klebe- und Ablöserolleneinheit 30 längs den Gleitschienen 33 in den Figuren 1 und 2 nach rechts bewegt, bewegen sich die Rollen 31, 32 der Klebe- und Ablöserolleneinheit 30 in der durch einen Pfeil angedeuteten Richtung von der strichpunktierten Linie zu der ausgezogenen Linie in Fig. 14, und in diesem Fall werden der Motor M3 und der Drehmomentmotor M4 gleichzeitig angetrieben. Da dem Ablöseband eine bestimmte Spannung erteilt worden ist, wird nun die Drehung des Drehmomentmotors M4 zur Bandaufwickelwelle 55 mittels der Riemenscheibe 56, dem Riemen 58 und der Riemenscheibe 57 übertragen, so dass sich die Bandaufwickelwelle 55 dreht und somit verursacht, dass das Ablöseband 3 von der Oberfläche des Wafers W zusammen mit dem Oberflächenschutzband 2 (2a), das am Ablöseband klebt, abgelöst wird.

Da die entsprechenden zerbrochenen Oberflächenschutzbänder 2a gebogen sind und deshalb leichter von der Oberfläche des Wafers abgelöst werden können, wie es oben (s. Fig. 16) beschrieben wurde, kleben nun diese Oberflächenschutzbänder 2a am Ablöseband 3; die Oberflächenschutzbänder 2a können somit leicht von der Oberfläche des Wafers W abgelöst werden.

Dann wird das von der Oberfläche des Wafers W abgelöste Ablöseband 3 auf die Bandaufwickelwelle 55 der Bandaufwickeleinheit 50 zusammen mit dem auf diesem klebenden Oberflächenschutzband 2a zwecks Einsammelns aufgewickelt.

Gemäß dem Vorstehenden und diesem Ausführungsbeispiel schrumpfen die zerbrochenen Oberflächenschutzbänder 2 (2a), während sie am Ablöseband kleben, weil das über die ganze Fläche des Oberflächenschutzbands 2 angeklebte Ablöseband 3 zusammen mit dem Oberflächenschutzband 2 (2a) erhitzt wird, so dass das zerbrochene Oberflächenschutzband 2a von der Oberfläche des Wafers W leicht abgelöst werden kann, wobei der Vorgang der Ablösung des Oberflächenschutzbands 2 (2a) dadurch wirksam ausgeführt werden kann, dass eine Folge dieser Schritte von der Ablösevorrichtung 1 durchgeführt wird, die den Saugtisch 10, die Ablösebandeinheit 20, die Klebe- und Ablöserolleneinheit 30, die Heiz- und Kühleinheit 40 und die Bandaufwickeleinheit 50 aufweist.

Bei diesem Ausführungsbeispiel wird auch ein Endlosband für das Ablöseband 3 verwendet, so dass die zerbrochenen Oberflächenschutzbänder 2a nacheinander an das Endlosband 3 angeklebt und in wirksamer Weise von der Oberfläche des Wafers zwecks Einsammelns abgelöst werden können.

Ferner kann die Ablösevorrichtung 1 im Aufbau vereinfacht und in den Kosten vermindert werden, weil in diesem Ausführungsbeispiel die Ablösebandklebemittel und Bandablösemittel durch die gemeinsame Klebe- und Ablöserolleneinheit 30 gebildet werden.

Andererseits kann die Betriebszeit zur weiteren Erhöhung der Wirksamkeit vermindert werden, weil bei diesem Ausführungsbeispiel das erhitzte Ablöseband 3 und das Oberflächenschutzband 2 (2a) abgekühlt werden.

Während ein Teil der Vorgänge (beispielsweise das Anbringen des Wafers W auf dem Saugtisch 10) in der Ablösevorrichtung 1 gemäß der vorliegenden Erfindung von Hand ausgeführt wird, kann auch eine vollautomatische Ablösevorrichtung verwirklicht werden, wenn sie so aufgebaut ist, dass sie alle Vorgänge automatisch durchführt.

### Zweites Ausführungsbeispiel

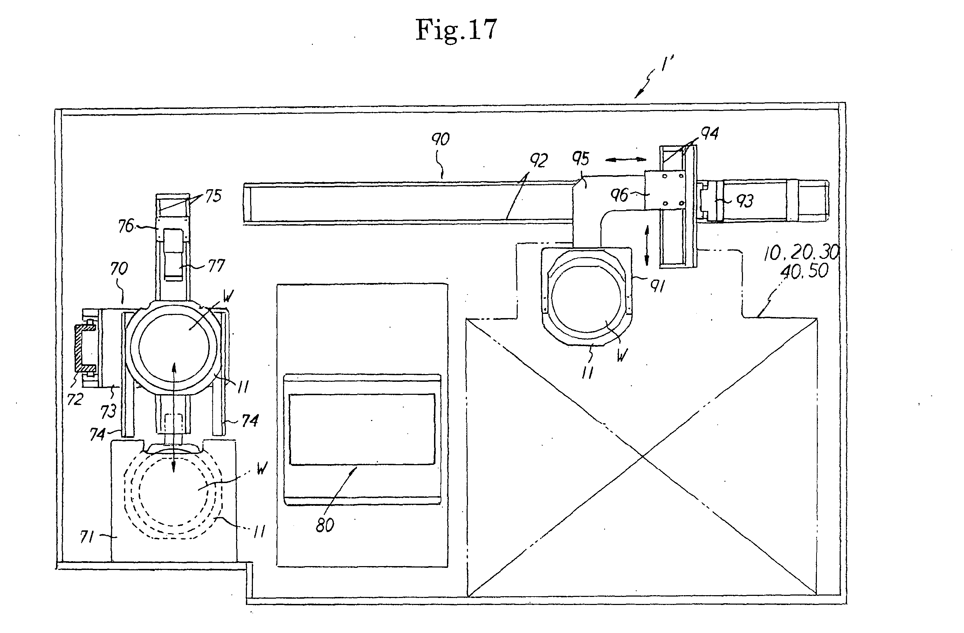

Nun wird ein zweites Ausführungsbeispiel gemäß der vorliegenden Erfindung anhand der Fig. 17 beschrieben. Die Fig. 17 zeigt eine Draufsicht auf eine Ablösevorrichtung gemäß dieser Erfindung.

Die Ablösevorrichtung 1 gemäß diesem Ausführungsbeispiel umfasst zusätzlich eine Rahmenklemmeinheit 70 zum automatischen Heranbringen und Entfernen eines Wafers (mit dem Ringrahmen 11 integriert) zu bzw. von einer Rahmenkassette 71 und eine UV-Lichtaussendeeinheit 80 zum Aussenden von Ultraviolettstrahlen (UV) an ein Oberflächenschutzband 2 (2a), das eine Klebeschicht 2B aufweist, die in Fig. 2B gezeigt ist und aus einem mit Ultraviolettlicht härtbaren Klebstoff besteht. Der übrige Aufbau ist derselbe wie der der Ablösevorrichtung 1 gemäß dem ersten Ausführungsbeispiel, d. h., dass er den Saugtisch 10, die Ablösebandeinheit 20, die Klebe- und Ablöserolleneinheit 30, die Heiz- und Kühleinheit 40 und die Bandaufwickeleinheit 50 aufweist.

Die Rahmenklemmeinheit 70 zieht einen von einer Vielzahl von in der Rahmenkassette 71 gespeicherten Wafern heraus, wobei die Wafer jeweils mit einem geeigneten Abstand voneinander vertikal in dieser Kassette angeordnet sind, löst das Oberflächenschutzband 2 (2a) von der Oberfläche des Wafers W ab und bringt den Wafer, von dem das Oberflächenschutzband 2 (2a) abgelöst worden ist, in die Rahmenkassette 71. Die Einheit 70 weist einen Tisch 73 auf, der sich vertikal längs einer vertikal angeordneten Gleitschiene 72 bewegen lässt. Zusätzlich ist ein Paar von Führungsschienen 74 auf dem Tisch 73 angeordnet, die parallel zueinander in Richtung einer Öffnung der Rahmenkassette 71 verlaufen. Ein Paar von Gleitschienen 75 sind parallel zwischen diesen Führungsschienen 74 angeordnet.

Eine Gleitvorrichtung 76 ist auf Gleitschienen 75 derart gleitend angeordnet, dass sie sich wechselseitig auf den Gleitschienen 75 bewegen kann, und eine Rahmenklemme 77 ist an der Gleitvorrichtung 76 zum Einklemmen des Wafers W (aktuell ein Ringrahmen 11) befestigt.

Die UV-Lichtaussendeeinheit 80 sendet fortwährend Ultraviolettstrahlen (UV) zum Oberflächenschutzband 2 (2a), das auf die Oberfläche des Wafers W geklebt ist. Wenn der von einem Saugarm 91 einer Trageinheit 90 getragene Wafer W mit dem nach unten orientierten Oberflächenschutzband 2 (2a) über der UV-Lichtaussendeeinheit 80 vorbeigeht, wird das Oberflächenschutzband 2 (2a) mit den Ultraviolettstrahlen beleuchtet.

Die Trageinheit 90 umfasst nun ein Paar von Gleitschienen 92, die in einer Richtung angeordnet sind, die senkrecht zu den Gleitschienen 75 steht, und die parallel zueinander verlaufen. Ferner ist eine Gleitvorrichtung 93 auf den Gleitschienen 92 gleitend angeordnet. Weiterhin wird ein Paar von Gleitschienen 94, die senkrecht zu den Gleitschienen 92 stehen und parallel zueinander verlaufen, durch die Gleitvorrichtung 93 getragen, wobei die Gleitschienen 94 längs der Gleitvorrichtung 93 auf und ab gleiten können (Vertikalrichtung auf dem Blatt der Fig. 17). Ein L-förmiger Tragarm 95 weist ein vom Saugarm 91 getragenes unteres Ende und ein von den Gleitschienen 94 mittels der Gleitvorrichtung 96 getragenes seitliches Ende auf. Der Tragarm 95 ist mit einem nicht gezeigten Mechanismus versehen, der den Saugarm 91 mit seiner Oberseite nach unten umdrehen kann.

Beim Vorgang des Ablösens des Oberflächenschutzbands 2 (2a) von einer Vielzahl von in der Rahmenkassette 71 gespeicherten Wafern W wird der Tisch 73 der Rahmenklemmeinheit 70 längs den Gleitschienen 72 auf und ab bewegt; dieser Tisch unterbricht seine Bewegung, wenn er eine Position in einer gewünschten Höhe des Wafers W erreicht. Die Rahmenklemme 77 gleitet auf den Gleitschienen 75 in Richtung der Rahmenkassette 71, klemmt einen gewünschten Wafer W (aktuell den Ringrahmen 11) ein, zieht diesen aus der Rahmenkassette 71 heraus, bewegt den Wafer zusammen mit dem Ringrahmen 11 längs den Führungsschienen 74 und trägt beide zu einer bestimmten Position, die durch eine ausgezogene Linie in Fig. 17 angedeutet ist.

Die Trageinheit 90 wird nun derart angetrieben, dass sie den am unteren Ende des Tragarms 95 befestigten Saugarm 91 längs den Gleitschienen 92 in Richtung auf die Rahmenklemmeinheit 70 und auch den Saugarm 91 längs den Gleitschienen 94 in eine Position bewegt, die durch eine ausgezogene Linie in Fig. 17 über dem wartenden Wafer W angedeutet ist. Dann wird der Saugarm 91 erneut nach oben bewegt und längs den Gleitschienen 92 verschoben, so dass er am Wafer W über der UV-Lichtaussendeeinheit 80 längs den Gleitschienen 92 vorbeigeht und das auf der Oberfläche des Wafers W aufgeklebte Oberflächenschutzband 2 (2a) mit Ultraviolettstrahlen (UV) bestrahlt wird. Danach wird der mit Ultraviolettlicht härtbare Klebstoff auf dem Oberflächenschutzband 2 (2a) gehärtet, so dass die Klebekraft des Oberflächenschutzbands 2 (2a) an der Oberfläche des Wafers W geschwächt wird. In diesem Fall wird der Wafer in einer derartigen Orientierung getragen, dass seine Oberfläche, auf der das Oberflächenschutzband 2 (2a) angeklebt ist, nach unten zeigt.

Wenn das Oberflächenschutzband 2 (2a) mit Ultraviolettstrahlen, wie oben beschrieben, bestrahlt worden ist, wird der Saugarm 91 längs den Gleitschienen 92 der Trageinheit 90 bewegt; der Saugarm 91 dreht den Wafer W mit der Oberseite nach unten und setzt diesen mit derjenigen Fläche nach oben auf dem Saugtisch 10, auf der das nach oben gerichtete Oberflächenschutzband 2 aufgeklebt ist, in einer Weise ab, die derjenigen entspricht, die für die Ablösevorrichtung 1 des beschriebenen ersten Ausführungsbeispiels vorgesehen ist. Danach wird das auf der Oberfläche des Wafers W aufgeklebte Oberflächenschutzband 2 (2a) in einer Weise von diesem Wafer abgelöst und entfernt, die derjenigen entspricht, die für die Ablösevorrichtung 1 des beschriebenen ersten Ausführungsbeispiels vorgesehen ist.

Dann wird der Wafer W, von dem die zerbrochenen Oberflächenschutzbänder aa abgelöst und entfernt worden sind, vom Saugarm 91 angesaugt und in eine bestimmte Position (angedeutet durch eine ausgezogene Linie in Fig. 17) auf den Führungsschienen 74 der Rahmenklemmeinheit 70 gebracht und längs den Führungsschienen 74 durch die Gleitvorrichtung 76 in Richtung zu der Rahmenkassette 71 geschickt, wobei er von der Rahmenklemme 77 zum Speichern an einer bestimmten Stelle in der Rahmenkassette 71 eingeklemmt bleibt.

Durch Wiederholen der vorstehenden Vorgänge können die Oberflächenschutzbänder 2 (2a) vollautomatisch von den Flächen einer Vielzahl von Wafern W abgelöst werden, so dass Arbeit eingespart und der Betriebswirkungsgrad erhöht wird.

In der Ablösevorrichtung 1' gemäß diesem Ausführungsbeispiel wird auch das Oberflächenschutzband 2 (2a) mit Ultraviolettstrahlen durch die UV-Lichtaussendeeinheit 80 als ein vorhergehender Schritt bestrahlt, so dass der mit Ultraviolettlicht härtbare Klebstoff des Oberflächenschutzbands 2 (2a) gehärtet wird und somit die Klebekraft des Oberflächenschutzbands 2 (2a) geschwächt wird. Daher können die zerbrochenen Oberflächenschutzbänder zusammen mit Ablöseband zwecks Einsammelns leicht von der Oberfläche des Wafers abgelöst werden.

Im Übrigen sieht die Ablösevorrichtung 1' gemäß diesem Ausführungsbeispiel die gleichen Wirkungen vor wie diejenigen, die im vorstehenden ersten Ausführungsbeispiel vorhanden sind.

### Drittes Ausführungsbeispiel

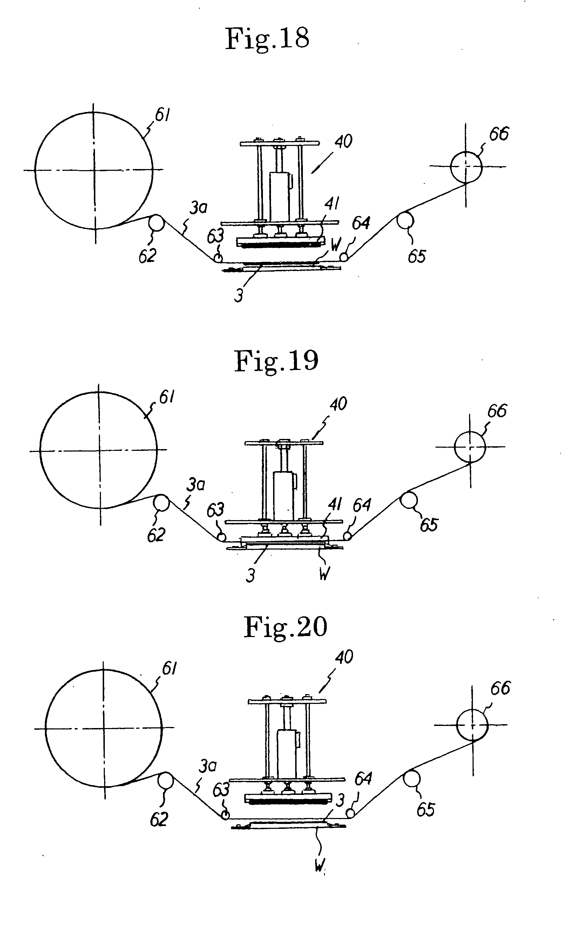

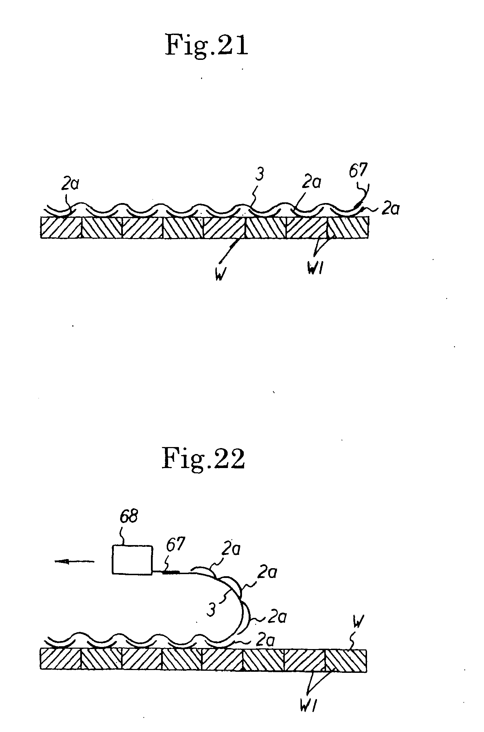

Ein drittes Ausführungsbeispiel gemäß der vorliegenden Erfindung wird nun anhand der Figuren 18 bis 22 beschrieben. Die Figuren 18 bis 22 stellen Erläuterungsdiagramme dar, die ein Ablöseverfahren zeigen, das unter Verwendung einer Ablösevorrichtung gemäß dem dritten Ausführungsbeispiel der vorliegenden Erfindung in einer Folge von Schritten durchgeführt wird. Die Fig. 21 zeigt einen Querschnitt durch einen Wafer mit Oberflächenschutzband, wobei dieser Querschnitt den Zustand eines erhitzten Oberflächenschutzbands und Ablösebands zeigt. Die Fig. 22 zeigt einen der Fig. 21 ähnlichen Querschnitt, aus dem ersichtlich ist, wie das Ablöseband und das Oberflächenschutzband von der Fläche eines Wafers abgelöst werden.

Nach dem Ablöseverfahren gemäß diesem Ausführungsbeispiel werden die auf der Fläche des Wafers W aufgeklebten und in chipgroße Stücke zerbrochenen Oberflächenschutzbänder 2a in derselben Weise von der Fläche des Wafers W wie im Fall des vorbeschriebenen ersten und zweiten Ausführungsbeispiels abgelöst, doch zum Unterschied zu diesen Ausführungsbeispielen wird ein ringförmiges Band, das vorher in Übereinstimmung mit der Oberflächenform des Wafers W geschnitten wird, als Ablöseband 3 verwendet.

Im Einzelnen ist bei diesem Ausführungsbeispiel eine Vielzahl von ringförmigen Ablösebändern, die vorher in Übereinstimmung mit der Oberflächenform des Wafers W geschnitten worden waren, vorübergehend auf eine blattförmige Abdeckschicht 3a geklebt worden, die auf einer Ablösebandrolle 61 in geeigneten Intervallen gewickelt ist, wie in Fig. 18 dargestellt Die von der Ablösebandrolle 61 abgewickelte Abdeckschicht 3a wird durch Rollen 62-65 geführt und auf eine Aufwickelwelle 66 aufgewickelt.

Das Oberflächenschutzband 2 weist nun eine auf der Oberfläche einer Wärmeschrumpfbasis in gleicher Weise wie im vorbeschriebenen ersten Ausführungsbeispiel aufgebrachte Klebeschicht auf, während als Ablöseband 3 ein wärmeempfindliches Klebeband verwendet wird, das eine wärmeempfindliche Klebeschicht aufweist, die auf einer wärmefesten Folie, beispielsweise Polyethylenterephthalat, abgelagert ist.

Wie in Fig. 18 dargestellt ist, wird die im Wesentlichen horizontale Abdeckschicht 3a über dem Wafer W von zwei Rollen 63, 64 gespannt. Ein ringförmiges Ablöseband 3, das vorübergehend auf der unteren Oberfläche der Abdeckschicht 3a aufgeklebt ist, ist über dem Wafer W angeordnet.

Nun wird der Heizkörper 41 der Heiz- und Kühleinheit 30 nach unten bewegt, so dass der Heizkörper 41 das Ablöseband 3 auf das Oberflächenschutzband 2 auf der Oberfläche des Wafers drückt und das Ablöseband 3 zusammen mit dem Oberflächenschutzband 2 auf eine bestimmte Temperatur aufheizt, wie es in Fig. 19 dargestellt ist. Daher wird das vorher in eine Ringform geschnittene Ablöseband 3 auf die ganze Oberfläche des Oberflächenschutzbandes 2 auf der Oberfläche des Wafers W geklebt.

Wie oben beschrieben wurde, weist das Oberflächenschutzband 2 eine auf der Oberfläche einer Wärmeschrumpfbasis aufgebrachte Klebeschicht auf, so dass bei der Erhitzung dieser Basis diese schrumpft und sich die entsprechenden zerbrochenen Oberflächenschutzbänder 2a biegen, wie es in Fig. 21 dargestellt ist. Daher steht jedes der zerbrochenen Oberflächenschutzbänder 2a in Kontakt mit der Oberfläche des Wafers W auf einer verminderten Fläche in Kontakt, so dass jedes Oberflächenschutzband 2a von der Oberfläche des Wafers W leichter abgelöst werden kann.

Wenn der Heizkörper 41 der Heiz- und Kühleinheit 40 nach oben bewegt wird, wird das Ablöseband 3 nun von der Abdeckschicht 3a getrennt, und das Ablöseband 3 bleibt auf der Oberfläche des Wafers W, wie es in Fig. 20 dargestellt ist, so dass die Abdeckschicht 3a durch die Rollen 64, 65 allein geführt und auf die Aufwickelwelle 66 aufgewickelt wird.

Wie in Fig. 21 dargestellt ist, wird nun ein Ende eines Klebebands 67 an ein Ende des Ablösebands 3 angeklebt, das auf die ganze Fläche des Oberflächenschutzbandes auf der Oberfläche des Wafers W geklebt worden war. Dieses Klebeband 67 wird in einer von der Seite gesehenen U-Form zurückgefaltet, wie es aus der Fig. 22 hervorgeht. Wenn nun das andere Ende des Klebebands 67 durch einen Ablösekopf 68 abgetrennt und in eine Richtung bewegt wird, die durch einen Pfeil in Fig. 22 angedeutet ist, werden das Ablöseband und die an diesem angeklebten Oberflächenschutzbänder 2a durch den Ablösekopf 68 gezogen und darauf von der Oberfläche des Wafers W zwecks Einsammelns abgelöst.

Wie oben beschrieben wurde, sind die entsprechenden zerbrochenen Oberflächenschutzbänder 2a gebogen; sie neigen daher zur leichten Ablösung von der Oberfläche des Wafers W, so dass diese Oberflächenschutzbänder 2a am Ablöseband 3 derart kleben, dass sie tatsächlich leicht von der Oberfläche des Wafers W abgelöst werden können.

Wie oben beschrieben wurde, können bei diesem Ausführungsbeispiel die zerbrochenen Oberflächenschutzbänder 2a von der Oberfläche des Wafers W leicht und wirksam abgelöst werden, und deshalb sieht dieses Ausführungsbeispiel die gleichen Wirkungen wie diejenigen des vorbeschriebenen ersten Ausführungsbeispiels vor.

### Industrielle Verwertbarkeit

Die vorliegende Erfindung kann bei Verfahren und Vorrichtungen zum Ablösen eines Klebebands derart angewandt werden, dass ein auf der Oberfläche eines plattenförmigen Körpers geklebtes und in chipgroße Stücke zerbrochenes Oberflächenschutzband vom plattenförmigen Körper abgelöst wird; ferner kann die Erfindung auf dem Gebiet der Herstellung optischer Vorrichtungen und elektronischer Komponenten, beispielsweise Linsen, Wellenlängenumwandlungsvorrichtungen und dergleichen, außerhalb des Gebiets der Halbleiterherstellung angewandt werden.

### Bezugszeichenliste

- 1: Ablösevorrichtung
- 2: Oberflächenschutzband (Klebeband)
- 2A: Wärmschrumpfbasis
- 2B: Klebeschicht
- 2a: Zerbrochenes Oberflächenschutzband (Klebeband)
- 3: Ablöseband
- 3a: Abdeckschicht
- 10: Saugtisch
- 12: Ringrahmen
- 20: Ablösebandeinheit (Ablösebandzuführmittel)
- 21: Ablösebandrolle
- 25: Deckschichtaufwickelwelle
- 30: Klebe- und Ablöserolleneinheit (Ablösebandklebemittel bzw. Bandablösemittel)
- 31, 32: Rollen
- 33: Gleitschiene
- 34: Gleitbahn
- 35: Einachsiger Bewegungsautomat
- 37: Vertikal bewegbarer Zylinder
- 40: Heiz- und Kühleinheit (Heizmittel, Kühlmittel)
- 41: Heizkörper
- 44: Gleitzylinder
- 50: Bandaufwickeleinheit (Einsammelmittel)
- 55: Ablösebandaufwickelwelle
- 61: Ablösebandrolle
- 62-65: Rollen
- 66: Aufwickelwelle
- 67: Klebeband
- 68: Ablösekopf
- 70: Rahmenklemmeinheit
- 71: Rahmenkassette
- 72: Gleitschiene
- 73: Tisch
- 74: Führungsschiene
- 75: Gleitschiene
- 76: Gleitvorrichtung
- 77: Klemmrahmen
- 80: UV-Strahlenaussendeeinheit (Ultraviolettstrahlenaussendemittel)
- 90: Trageinheit
- 91: Saugarm
- 92: Gleitschiene
- 93: Gleitvorrichtung
- 94: Gleitschiene
- 95: Tragarm
- 96: Gleitvorrichtung
- W: Halbleiterwafer (plattenförmiger Körper)
- W1: Zerbrochener Halbleiterwafer
- M1-M4: Motoren

## Patentansprüche

1. Vorrichtung zum Ablösen eines auf die Oberfläche eines plattenförmigen Körpers geklebten und in chipgroße Stücke zerbrochenen Klebebands vom plattenförmigen Körper,
**gekennzeichnet durch** folgende Komponenten:
- Ablösebandzuführmittel zur Zuführung eines Ablösebands zum plattenförmigen Körper, der auf einem Saugtisch gehalten wird,
- Ablösebandklebemittel zum Ankleben des aus den Ablösebandzuführmitteln zugeführten Ablösebands an die ganze Fläche des auf der Oberfläche des plattenförmigen Körpers aufgeklebten Klebebands,
- Heizmittel zur Erhitzung des an der ganzen Fläche des Klebebands **durch** die Ablösebandklebemittel angeklebten Ablösebands zusammen mit dem Ablöseband,
- Ablösemittel zum Ablösen des auf das Ablöseband **durch** Erhitzen mit den Heizmitteln aufgeklebten Klebebands vom plattenförmigen Körper zusammen mit dem Ablöseband und
- Einsammelmittel zum Einsammeln des Klebebands und des vom plattenförmigen Körper **durch** die Bandablösemittel abgelösten Ablösebands.

2. Vorrichtung nach Anspruch 1,
**dadurch gekennzeichnet,**
**dass** ein blattförmiges Endlosband als Ablöseband verwendet wird und dass die Ablösbandklebemittel und die Bandablösemittel durch eine gemeinsame Rolleneinheit gebildet sind.

3. Vorrichtung nach Anspruch 1,
**dadurch gekennzeichnet,**
**dass** ein Band, das vorher in Übereinstimmung mit der Oberflächenform des plattenförmigen Körpers zerschnitten ist, als Ablöseband verwendet wird, wobei ein zweites Klebeband, das an ein Ende des Ablösebands geklebt ist, gehalten und von einem Ablösekopf abgezogen wird, wobei das Klebeband vom plattenförmigen Körper zusammen mit dem Ablöseband abgelöst wird.

4. Vorrichtung nach Anspruch 1,
**dadurch gekennzeichnet,**
**dass** das Klebeband eine Klebeschicht aufweist, das auf einer Wärmeschrumpfbasis aufgebracht ist.

5. Vorrichtung nach Anspruch 4,
**dadurch gekennzeichnet,**
**dass** die Klebeschicht des Klebebands aus einem mit Ultraviolettlicht härtbaren Klebstoff hergestellt ist und dass die Vorrichtung ferner ein Ultraviolettlicht aussendendes Mittel zur Beleuchtung des Klebebands mit Ultraviolettstrahlen aufweist.

6. Vorrichtung nach Anspruch 1,
**dadurch gekennzeichnet,**
**dass** Kühlmittel zum Kühlen des Ablösebands und des durch die Heizmittel erhitzten Klebebands vorgesehen sind.
